# FASCICULE DE BREVET EUROPEEN

(11) **EP 3 490 928 B1**
(45) Date de publication et mention de la délivrance du brevet: **11.08.2021**
(21) Numéro de dépôt: 17757791.3
(22) Date de dépôt: 25.07.2017
(51) Int. Cl.: B81C 1/00, G01N 29/02, G01N 29/036

(54) **CAPTEUR CHIMIQUE RESONANT COMPORTANT UN DISPOSITIF DE FONCTIONNALISATION ET SON PROCEDE DE REALISATION**
RESONANTER CHEMISCHER SENSOR MIT EINER FUNKTIONALISIERUNGSVORRICHTUNG UND VERFAHREN ZUR HERSTELLUNG DAVON
RESONANT CHEMICAL SENSOR COMPRISING A FUNCTIONALISATION DEVICE AND METHOD FOR THE PRODUCTION THEREOF

(30) Priorité: 28.07.2016 FR 1657301
(43) Date de publication de la demande: 05.06.2019
(73) Titulaire: Commissariat à l'Energie Atomique et aux Energies Alternatives, 75015 Paris (FR)
(72) Inventeur: CLARET, Thierry, 38119 Pierre Chatel (FR); BOTTAUSCI, Frédéric, 83370 Saint-Aygulf (FR); PARAT, Guy-Michel, 38640 Claix (FR); VIGNOUD, Séverine, 38190 Bernin (FR)
(74) Mandataire: Brevalex
(86) Numéro de dépôt international: PCT/FR2017/052050
(87) Numéro de publication internationale: WO 2018/020130

(56) Documents cités:
- WO-A1-02/095940
- WO-A1-2013/171144
- WO-A1-2015/097282
- US-A1- 2006 104 864
- US-A1- 2006 280 931

## Description

La présente demande a trait au domaine des capteurs chimiques à transduction mécanique, et notamment ceux dédiés à la détection d'espèce(s) chimique(s) sous forme gazeuse. Elle concerne plus particulièrement la mise en œuvre de capteurs chimiques résonants et/ou dotés de moyens de transduction piézoélectriques améliorés.

Le principe de fonctionnement d'un capteur à transduction mécanique repose sur la mise en oscillation d'un élément dont la fréquence vibratoire est dépendante d'une espèce chimique à quantifier.

Les capteurs chimiques de type résonateur acoustique sont basés sur une mesure d'une variation de la fréquence de résonance du capteur ou plus rarement sur une mesure de déphasage. Ces capteurs sont obtenus en recouvrant une face d'un transducteur de type résonateur acoustique, par exemple un transducteur piézoélectrique muni d'une couche sensible à base d'un matériau capable d'adsorber et/ou absorber les espèces chimiques à détecter.

Quand une ou plusieurs espèces à détecter interagit avec la couche sensible, la masse de la couche sensible augmente, ce qui entraine une baisse de la fréquence de résonance du transducteur. La masse adsorbée sur la couche sensible induit donc un changement de la fréquence de résonance du transducteur, qui peut être mesurée. Dans certains cas, c'est le décalage de phase du résonateur acoustique qui est utilisé pour la mesure.

Il existe des capteurs chimiques résonants dont la couche sensible est organique et notamment à base d'un matériau polymère.

L'intégration d'une telle couche dans une structure de détection d'un capteur peut s'avérer complexe car certains matériaux organiques sont difficiles à structurer et ne sont en particulier pas adaptés à une structuration par photolithographie.

Par ailleurs, une couche sensible en matériau polymère peut se dégrader ce qui peut limiter la durée de vie du capteur.

En outre, avec certains matériaux comme par exemple le polyvinylalcool, le poly(hydroxy)styrène, le polyimide, le polyéthylène oxyde et le polyvinylcarbazole ces mêmes polymères incompatibles avec une étape de stripping de lithographie usuelle et procédé de réalisation associés il peut s'avérer difficile d'obtenir une couche sensible d'épaisseur uniforme et/ou contrôlée.

Le document : "Piezoelectric sensor using a porous alumina film covered with a catalytic material", de K. Hohkawa, et al., IEEE Ultrasonic Symp. Proc. 1 (1998) 513-516 présente par ailleurs un capteur de gaz résonant de type SAW (pour « Surface Acoustic Waves ») doté d'une structure sensible poreuse associée à une couche catalytique inorganique. Ce capteur est destiné à piéger des gaz tels que le CO par réaction avec la couche catalytique de type Pt ou Co déposé sur la structure d'alumine poreuse.

Le document « Ammonia détection using nanoporous alumina resistive and surface acoustic wave sensors », de Oomman K. Vargehse et al., Sensors and actuators, 2003, présente un également un capteur SAW à structure sensible en alumine, appliqué cette fois à la détection d'ammoniac.

US 2006/104864 A1 et WO 2013/171144 A1 présentent des capteurs chimiques résonants aux structures sensibles poreuses.

Il se pose le problème de réaliser un capteur chimique amélioré vis-à-vis d'inconvénients mentionnés ci-dessus.

### EXPOSÉ DE L'INVENTION

Un mode de réalisation de la présente invention prévoit un capteur chimique selon la revendication 1 doté d'au moins une structure de détection à transduction mécanique, ladite structure de détection étant munie d'au moins une couche à base de matériau poreux avec des pores remplis ou tapissés d'au moins une première couche à base d'un premier matériau apte à adsorber ou absorber au moins une première espèce chimique.

L'utilisation d'un matériau poreux servant de matrice d'accueil d'un premier matériau apte à absorber et/ou adsorber au moins une espèce chimique d'intérêt permet un large choix de premier matériau et éventuellement d'utiliser un premier matériau plus fragile que le matériau poreux formant la matrice.

L'invention permet ainsi l'utilisation de matériau de fonctionnalisation organique et de réaliser un capteur amélioré en termes de robustesse et de durée de vie.

Le matériau poreux peut être également un matériau dont les dimensions peuvent être contrôlées aisément et dans lequel on intègre un matériau dont la structuration est plus difficile à contrôler.

Le matériau poreux peut être par exemple de l'alumine poreuse ou du silicium poreux.

Le premier matériau est un matériau organique micro-poreux ou nano-poreux.

Le premier matériau peut être choisi parmi les matériaux suivants : matériau hybride organique-inorganique, matériau polymère.

Par « micro-poreux », on entend une taille de pores inférieure à 2 nanomètres.

Par « nano-poreux », on entend une taille de pores inférieure à 1 nanomètre.

La taille des pores, au sens de la présente invention, correspond à la plus grande dimension (la plus grande des dimensions du volume de la cavité définie par le pore) desdits pores.

Il est par ailleurs entendu que les dimensions d'un pore (profondeur et/ou largeur) peuvent être mesurées par microscopie électronique à transmission (« TEM » ou « Transmission Electronic Microscopy » selon la terminologie Anglo-Saxonne) ou par le technique BET (Brunauer, Emmett et Teller).

Avantageusement, le premier matériau est micro-poreux ou nano-poreux et présente une fonction organique à base de silane (par exemple 11-pentafluorophenoxyundecyltriméthoxysilane) ou à base de silice microporeuse rendue organique, par exemple par un traitement de silanisation.

Avantageusement, le matériau poreux comporte des pores remplis en outre d'au moins une deuxième couche disposée sur et en contact de la première couche, la deuxième couche étant à base d'un deuxième matériau, différent dudit premier matériau et apte à adsorber ou absorber au moins une deuxième espèce chimique différente de la première espèce chimique. Avec une telle configuration, on peut avantageusement mettre en œuvre une détection de plusieurs espèces chimiques différentes avec un même capteur.

Le deuxième matériau est typiquement un matériau organique.

Le deuxième matériau peut être choisi parmi les matériaux suivants : matériau hybride organique-inorganique, matériau micro-poreux ou nano-poreux, matériau polymère.

Le capteur chimique est en particulier adapté à la détection de gaz.

Selon un mode de réalisation, le capteur chimique comporte une couche de fonctionnalisation adaptée pour adsorber ou absorber du CO₂, et au moins une autre couche parmi lesdites couches de fonctionnalisation adaptée pour adsorber ou absorber du H₂.

Selon un autre mode de réalisation, le capteur chimique comporte une couche de fonctionnalisation adaptée pour adsorber ou absorber un composé organique de type BTEX (Benzène, Toluène, Éthylbenzène et Xylènes).

Le matériau poreux est revêtu d'une couche de fermeture des pores, la couche de fermeture recouvrant la ou les couches de fonctionnalisation et étant adaptée, en termes de composition et d'épaisseur pour laisser une ou plusieurs espèces chimiques pénétrer à l'intérieur des pores et empêcher une ou plusieurs autres espèces chimiques de pénétrer à l'intérieur des pores. La couche de fermeture a ainsi une perméabilité sélective.

Selon un mode de réalisation, on prévoit une couche de fermeture soit hydrophobe afin d'empêcher des molécules d'eau de pénétrer dans les pores, soit filtrante par rapport à certaines molécules pour assurer une discrimination des molécules présentant de l'affinité avec les matériaux de fonctionnalisation. A titre d'exemple de couche hydrophobe, on peut utiliser du Silane FDTS .

La présente invention s'applique tout particulièrement à un capteur muni d'une structure de détection résonante et/ou à transduction piézoélectrique.

Selon un autre aspect, la présente invention concerne un procédé de réalisation d'un capteur tel que défini plus haut.

Un mode de réalisation d'un tel procédé prévoit en particulier la formation de la première couche de fonctionnalisation à l'aide d'au moins un dépôt en phase liquide d'une solution liquide sur la couche de matériau poreux.

On peut ainsi intégrer aisément dans une matrice poreuse un matériau sensible, par exemple en polymère, apte à absorber et/ou adsorber au moins une espèce chimique d'intérêt.

On peut en particulier intégrer un matériau incompatible avec un procédé de lithographie dans un matériau poreux qui peut avoir été préalablement structuré. Dans ce cas, le matériau poreux peut être soumis à un procédé de lithographie avant d'accueillir le ou les matériaux de remplissage des pores. On peut ainsi définir des motifs dans le matériau poreux de manière similaire à un procédé de lithographie classique, puis déposer un ou plusieurs matériaux de remplissage sensibles à une ou plusieurs espèces chimiques à détecter mais qui sont plus fragiles ou difficiles à modeler que le matériau poreux.

Un mode de remplissage du matériau poreux comprend une étape de mise en rotation d'un support sur lequel la couche de matériau poreux est disposée.

On peut également prévoir un remplissage en utilisant une racle pour étaler ladite solution liquide sur le matériau poreux.

Lorsque l'on souhaite intégrer plusieurs couches de fonctionnalisation au sein des pores du matériau poreux, on peut prévoir la formation d'une première couche de fonctionnalisation par dépôt conforme de sorte à tapisser les parois des pores tout en laissant au moins un volume vide dans les pores. Les pores sont ensuite remplis d'un deuxième matériau de sorte à former dans ledit volume au moins une deuxième couche de fonctionnalisation disposée sur et en contact de la première couche de fonctionnalisation.

Le matériau poreux peut être par exemple formé à partir d'une couche d'aluminium sur laquelle on effectue une oxydation par anodisation. On peut ainsi former de l'alumine poreuse.

Avantageusement, on peut prévoir que la couche rendue poreuse est disposée sur une couche barrière à l'oxydation afin de stopper la porosification. Par exemple lorsque le matériau poreux est formé par porosification d'une couche agencée sur une électrode du capteur, une couche barrière intermédiaire permet d'empêcher une porosification de l'électrode.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1 illustre un exemple de capteur de gaz de type BAW doté d'une structure de détection résonante avec un matériau poreux intégrant au moins une couche de fonctionnalisation dans ses pores ;
- la figure 2 illustre un exemple de configuration de matériau poreux intégré à une structure de détection d'un capteur, le matériau poreux ayant des pores comportant plusieurs couches de fonctionnalisation chacune adaptée à l'absorption ou l'adsorption d'une espèce chimique donnée ;
- la figure 3 illustre une variante de structure poreuse avec des pores intégrant des couches de fonctionnalisation et qui sont fermés par l'intermédiaire d'une couche de fermeture ;
- les figures 4 et 5 illustrent différents exemples de capteurs de gaz résonants de type FBAR avec une structure de détection résonante dotée d'un matériau poreux fonctionnalisé ;
- la figure 6 illustre un autre exemple de capteur chimique de type ondes de Lamb, structure de détection comportant un transducteur piézoélectrique et un matériau sensible poreux et fonctionnalisé ;
- les figures 7A-7B illustrent un exemple de capteur chimique de type à ondes de Lamb comportant une structure de détection résonante munie d'un matériau poreux fonctionnalisé ;
- les figures 8A-8B illustrent un exemple de procédé de réalisation d'une structure poreuse intégrant une couche de fonctionnalisation ;
- les figures 9A-9B illustrent une première méthode de remplissage d'une structure poreuse par un matériau de fonctionnalisation ;
- les figures 10A-10B illustrent une deuxième méthode de remplissage d'une structure poreuse par un matériau de fonctionnalisation ;
- la figure 11 illustre une étape de réalisation d'une couche de fonctionnalisation par dépôt conforme sur une structure poreuse;
- les figures 12A-12B illustrent une variante de réalisation d'une structure poreuse intégrant plusieurs couches de fonctionnalisation ;
- la figure 13 illustre une variante d'agencement de matériau poreux avec des pores comportant plusieurs couches de fonctionnalisation superposées ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, telle que « avant », « arrière », « supérieure », « inférieure » etc. d'une structure s'appliquent en considérant que la structure est orientée de la façon illustrée sur les figures.

### EXPOSÉ DÉTAILLÉ DE MODES DE RÉALISATION PARTICULIERS

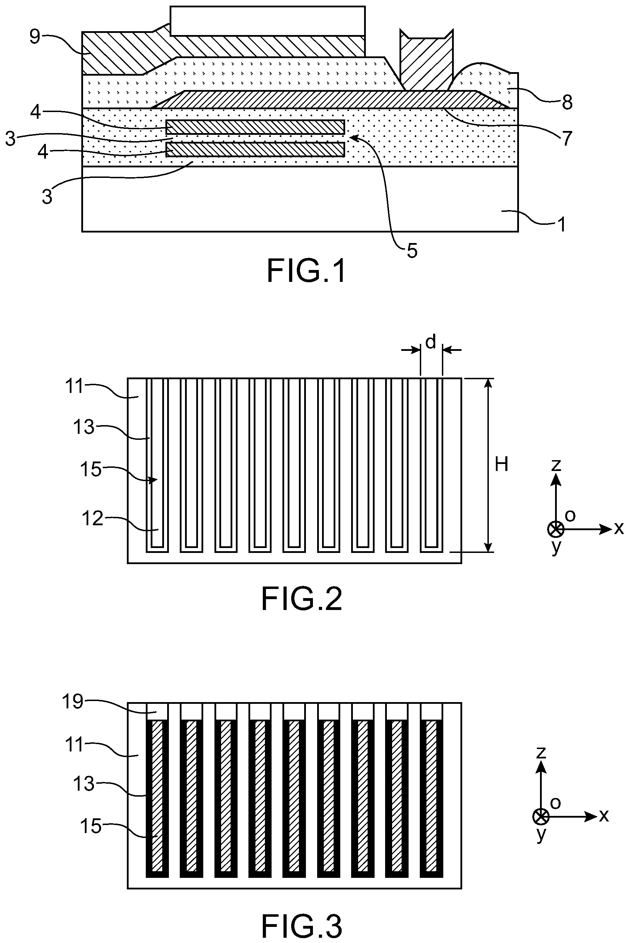

On se réfère à présent à la figure 1 donnant un exemple de capteur chimique mis en œuvre suivant un mode de réalisation de la présente invention. Le capteur est doté d'une structure de détection à transduction électromécanique, c'est-à-dire sensible à des variations de contraintes mécaniques sur celle-ci ou de masse de celle-ci, engendrée(s) lorsque des molécules, en particulier sous forme de gaz, sont absorbées par ou adsorbées sur la structure de détection. La structure de détection est par exemple à base d'un matériau piézoélectrique.

Le capteur représenté selon une vue en coupe est ici de type résonant c'est-à-dire avec une fréquence de résonance mécanique sensible aux variations de masse de la structure de détection en fonction de la quantité de molécules absorbées par ou adsorbées sur la structure de détection.

Dans cet exemple de réalisation particulier, le capteur chimique est à ondes acoustiques de volume (BAW pour « Bulk Acoustic wave ») avec une structure de détection piézoélectrique formée d'une électrode 7 inférieure et d'une électrode 9 supérieure entre lesquelles une couche de matériau piézoélectrique 8 est disposée. Le matériau piézoélectrique 8 est par exemple de l'AIN, tandis qu'on peut prévoir une électrode inférieure 7 par exemple en Molybdène. L'électrode supérieure 9 est en un matériau conducteur avantageusement apte à être rendu poreux tel que de l'Aluminium.

Lorsqu'un champ électrique oscillant est appliqué à la couche piézoélectrique par application d'une différence de potentiels entre l'électrode inférieure 7 et l'électrode supérieure 9, il en résulte une perturbation mécanique sous la forme d'ondes acoustiques.

Ces ondes se propagent dans le résonateur caractérisé par sa fréquence de résonance fonction du matériau piézoélectrique 8 et de la masse des différentes couches constituant l'empilement.

Dans le but d'avoir une relation entre la masse adsorbée ou adsorbée d'espèce(s) chimique(s) et la substance détectée, on prévoit une structure de détection très sélective dotée d'un matériau poreux 11 fonctionnalisé, c'est-à-dire muni d'un revêtement apte à absorber et/ou adsorber au moins une espèce chimique particulière. Le matériau poreux 11 fonctionnalisé est ici disposé sur l'électrode supérieure 9 ou formée dans une portion de l'électrode supérieure 9.

La structure de détection résonante est agencée sur un support 1, par exemple sur un substrat semi-conducteur, typiquement en silicium.

Un moyen d'isolation acoustique sous forme d'un réflecteur acoustique est prévu entre la structure de détection résonante et le substrat 1. Dans cet exemple, le résonateur BAW est isolé du substrat par un réflecteur acoustique 5 sous forme d'un miroir de Bragg. Un tel réflecteur 5 est typiquement formé d'un empilement alterné de premières couches 3 en un matériau à faible impédance acoustique et de deuxièmes couches 4 en un matériau à haute impédance acoustique. On choisit par exemple un miroir de Bragg formé d'une alternance de matériau électriquement conducteur et de matériau isolant. Par exemple, les premières couches 3 sont en oxyde de silicium et les deuxièmes couches 4 sont en tungstène.

Un exemple de configuration du matériau poreux 11 fonctionnalisé intégré à la structure de détection est donné de manière schématique sur la figure 2.

Le matériau poreux 11 peut être formé par porosification du matériau de l'électrode 9 supérieur, par exemple de l'alumine poreuse réalisée par un procédé de porosification d'aluminium. En variante, le matériau poreux est formé par porosification d'un matériau recouvrant l'électrode 9 supérieure et différent de celui de cette électrode 9, par exemple du silicium ou de l'oxyde de silicium ou de l'oxyde de titane.

Le matériau poreux 11 comporte typiquement des pores 12 avec un rapport de forme H/d, i.e. de hauteur H sur leur dimension critique d, élevé, c'est-à-dire d'au moins 10. Par « dimension critique » d, on entend ici la plus petite dimension des pores hormis leur hauteur H, la hauteur H étant une dimension mesurée orthogonalement au plan principal de la couche poreuse, autrement dit orthogonalement au plan [0 ; x ; y] du repère [0; x; y; z] donné sur la figure 2. Par exemple, le rapport de forme H/d est typiquement compris entre 10 et plusieurs centaines.

Au moins une couche de fonctionnalisation est prévue à l'intérieur des pores 12, ceux-ci étant délimités par une paroi qui est tapissée par cette couche de fonctionnalisation. La couche de fonctionnalisation est configurée pour adsorber et/ou absorber une ou plusieurs espèces chimiques que le capteur chimique est amené à détecter.

On peut avantageusement prévoir plusieurs couches de fonctionnalisation différentes par pore. Dans l'exemple de configuration donné sur la figure 2, une première couche 13 de fonctionnalisation apte à adsorber et/ou absorber au moins une première espèce chimique et une deuxième couche 15 de fonctionnalisation apte à adsorber et/ou absorber au moins une deuxième espèce chimique différente de la première espèce chimique sont ainsi co-intégrés dans des mêmes pores 12, la deuxième couche 15 de fonctionnalisation étant disposée sur et en contact de la première couche 13 de fonctionnalisation.

Selon un agencement possible des couches de fonctionnalisation 13, 15 la première couche de fonctionnalisation 13 tapisse les parois des pores 15 tandis que la deuxième couche de fonctionnalisation 15 occupe le volume restant des pores 12.

La première espèce chimique et la deuxième espèce chimique à détecter peuvent être sous forme de gaz. Dans ce cas, les pores 12 sont dotés d'une couche de fonctionnalisation adaptée pour absorber un gaz et une autre couche de fonctionnalisation adaptée pour absorber un autre gaz.

Une application particulière du capteur chimique peut être par exemple la détection de CO₂ et de H₂. Par exemple, une couche de fonctionnalisation à base de silane et de type EHTES (2(3, 4 epoxy cyclohexyl) ethyl triethoxy silane) ou de type PFO-U-TMS (c'est-à-dire 11-pentafluorophenoxyundecyltriméthoxysilane) ou de silice microporeuse ayant subi un traitement de HMDS (hexaméthyldisilazane) ou de PVPh (poly(4-vinylphenol)) est adaptée à la détection de CO₂. Une autre couche de fonctionnalisation à base d'un matériau différent de celui de la première couche et qui peut être par exemple à base de Silane et de type APTES (3-Aminopropyl)triethoxysilane) ou EHTES, ou bien d'un matériau hybride organique inorganique tel que du SiOC, ou bien de la silice microporeuse fonctionnalisée par de l'EBTMOS (3,4-epoxybutyltrimethoxysilane) ou de l'APTES est adaptée à la détection de H₂.

Une variante d'agencement de la structure poreuse fonctionnalisée est donnée sur la figure 3 et prévoit l'intégration d'une couche d'encapsulation encore appelée couche de fermeture 19 agencée à l'embouchure des pores 12 de sorte à les obturer. La couche de fermeture 19 est configurée en termes d'agencement et de composition de sorte à empêcher certaines espèces chimiques de pénétrer dans les pores 12, tout en permettant à la première espèce chimique et à la deuxième espèce chimique à détecter de passer à travers cette couche 19 et s'introduire dans les pores 12. Selon un exemple de réalisation particulier, la couche de fermeture 19 peut être hydrophobe et adaptée pour permettre d'empêcher que des molécules d'eau puissent parvenir dans les pores 12. Un exemple de matériau pour une couche de fermeture 19 hydrophobe permettant au dioxyde de carbone (CO₂) de pénétrer dans les pores 12 est le silane FDTS (1H,1H,2H,2H-Perfluorodecyltrichlorosilane).

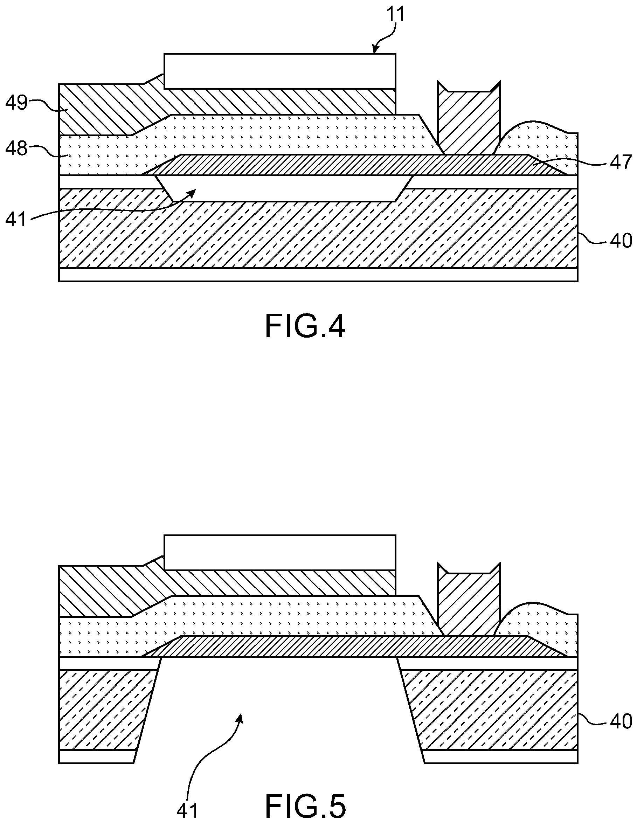

Un autre exemple de capteur résonant à ondes acoustiques, cette fois de type FBAR (pour « film bulk acoustic resonator »), est donné sur la figure 4.

Ce capteur diffère de celui décrit précédemment notamment en ce qu'il est doté d'une structure de détection suspendue au-dessus d'une cavité 41. La cavité 41 peut être définie entre l'électrode inférieure 47 d'une structure de détection à transduction piézoélectrique et une face supérieure d'un substrat 40 sur lequel des parties de la structure de détection reposent. La structure de détection piézoélectrique est formée d'un empilement comprenant une couche de matériau piézoélectrique 48 tel que de l'AIN sur laquelle repose l'électrode supérieure 49, la couche de matériau piézoélectrique 48 étant elle-même disposée sur une électrode inférieure 47. Dans ce type d'empilement, une couche diélectrique peut être prévue sous l'électrode inférieure 47 pour protéger l'électrode au moment de la gravure de la cavité 41. Cette couche diélectrique est continue sous l'ensemble de la structure piézoélectrique et peut être conservée dans l'empilement final. Une telle couche diélectrique peut être par exemple à base de SiN, ou de SiO₂, ou d'AIN.

La cavité 41 peut s'étendre dans une portion du substrat 40 ou traverser le substrat 40 comme sur la variante illustrée sur la figure 5.

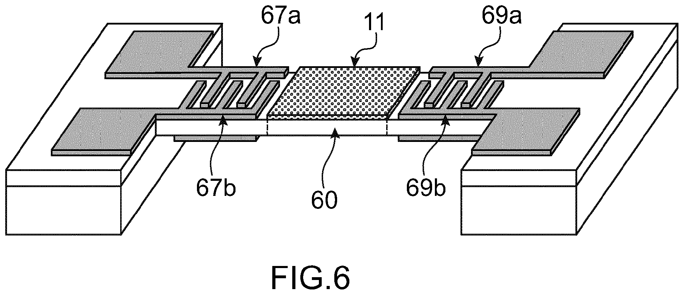

Un autre exemple de réalisation de capteur chimique résonant à base d'ondes de Lamb est donné sur la figure 6.

Dans cet exemple, le matériau poreux 11 fonctionnalisé est disposé sur une poutre suspendue 60 en matériau piézoélectrique, et placé sur le chemin d'ondes acoustiques émises par des électrodes 67a, 67b émettrices d'ondes acoustiques et reçues par des électrodes 69a, 69b réceptrices des ondes acoustiques.

Les électrodes 67a, 67b émettrices sont sous forme de peignes interdigités disposés à une première extrémité de la poutre, tandis que les électrodes 69a, 69b réceptrices sont également sous forme de peignes interdigités disposés à une deuxième extrémité de la poutre 60, à l'opposé de la première extrémité. La contrainte appliquée sur la poutre 60 varie en fonction de la quantité d'espèce chimique à détecter présente sur le matériau poreux 11, cette variation étant traduite par une variation de signal électrique aux bornes des électrodes réceptrices 69a, 69b.

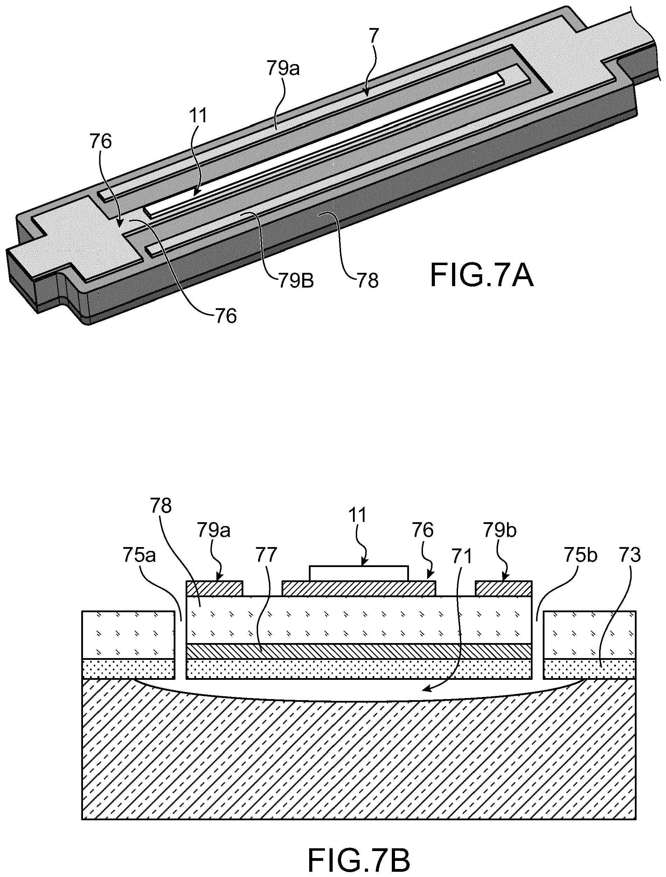

Un autre exemple de capteur résonant à onde de Lamb est illustré sur les figures 7A-7B. La structure de détection est également suspendue au-dessus d'une cavité 71. Le bloc de matériau poreux 11 fonctionnalisé est cette fois disposé sur une électrode 76, par exemple à base d'Aluminium elle-même reposant sur une couche 78 de matériau piézoélectrique. L'électrode 76 s'étend entre deux portions 79a, 79b d'une autre électrode 79 reposant sur la couche de matériau piézoélectrique 78, cette autre électrode 79 étant par exemple également à base d'aluminium. Les électrodes 76, 79 appelées électrodes « supérieures » forment un peigne interdigité.

On applique un champ électrique oscillant amené à engendrer des contractions et des expansions de la couche de matériau piézoélectrique 78 à l'origine d'ondes acoustiques appelées ondes de Lamb. La couche de matériau piézoélectrique 78 est disposée sur une couche conductrice 77, par exemple à base de Mo qui est typiquement reliée à la masse.

Cette couche conductrice 77 repose elle-même sur une couche isolante 73, par exemple à base de SiO₂.

Les électrodes 76, 79, la couche de matériau piézoélectrique 78, la couche conductrice 77 et une couche isolante 73 forment un bloc suspendu au-dessus de la cavité 71, ce bloc étant délimité latéralement par des tranchées 75a, 75b, agencées de part et d'autre du bloc et qui permettent de réfléchir les ondes acoustiques.

Un matériau poreux fonctionnalisé tel que décrit précédemment peut être intégré dans d'autres types de capteurs chimiques que ceux donnés précédemment à titre d'exemple, notamment dans des capteurs munis d'une structure de détection avec un résonateur mécanique à ondes acoustiques : en particulier un capteur SAW, ou un capteur MEMS ou NEMS muni d'une poutre vibrante.

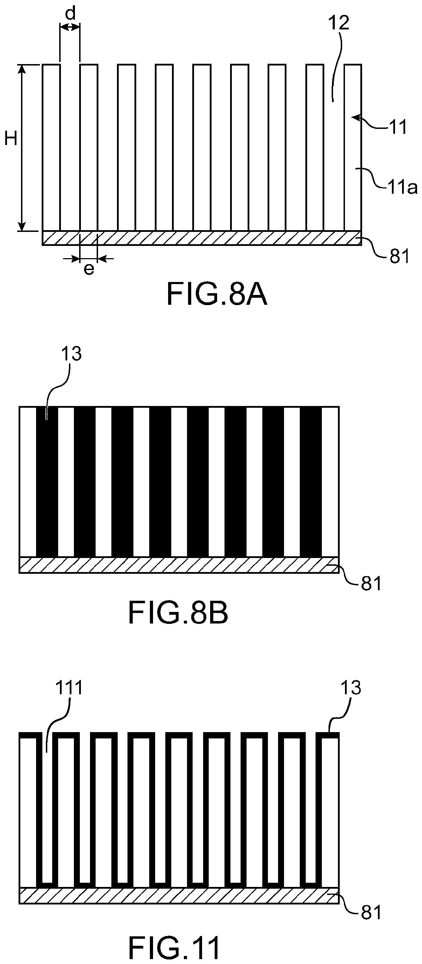

Un exemple de procédé de mise en œuvre d'une structure poreuse fonctionnalisée pour capteur chimique va à présent être donné en liaison avec les figures 8A-8B, 9A-9B, 10A-10B.

Le matériau de départ du procédé peut être une couche que l'on transforme en matériau poreux 11.

A ce stade, la couche que l'on souhaite rendre poreuse peut avoir été structurée, c'est-à-dire qu'un ou plusieurs motifs ont été réalisés dans cette couche par exemple à l'aide d'un procédé de photolithographie.

Le matériau poreux peut être par exemple de l'alumine que l'on rend poreuse par oxydation anodique (encore appelée anodisation) d'une couche d'aluminium.

L'épaisseur de la couche d'aluminium, qui peut être par exemple de plusieurs centaines de nanomètres est définie en fonction de la hauteur de la structure poreuse visée en tenant compte du coefficient d'expansion de la couche lors de l'anodisation. Le diamètre encore appelé dimension critique d des pores 12 de la structure est maîtrisé avec un procédé d'anodisation qui se déroule typiquement en quatre phases : une pré-anodisation, puis une première gravure permettant d'homogénéiser le diamètre des amorces de pores, puis une anodisation suivie d'une deuxième gravure pour élargir les pores 12. La pré-anodisation et l'anodisation s'effectuent typiquement en polarisant la couche à rendre poreuse dans des bains d'électrolytes comme l'acide phosphorique ou l'acide oxalique sous une tension constante, par exemple de 80V pour la pré-anodisation et de 80V pour l'anodisation, et sous une température donnée de plusieurs degrés Celsius.

Les deux phases de gravure sont de préférence réalisées à chaud, à une température de l'ordre d'une cinquantaine de degrés Celsius, par exemple à l'aide d'un bain d'acide phosphorique.

Un exemple de procédé d'anodisation qui peut être utilisé est donné dans le document : « Organized porous alumina membranes for high density silicon nanowires growth », de T. Bernardin, et al. Microelectronic Engineering, Volume 88, Septembre 2011, Pages 2844-2847 Elsevier. En fonction des paramètres du procédé choisi d'anodisation, lorsque le matériau poreux 11 est de l'alumine on forme par exemple des pores 12 ayant une organisation hexagonale et une dimension critique d comprise entre plusieurs dizaines de nanomètres et plusieurs centaines de nanomètres, par exemple de l'ordre de 300 nanomètres, une hauteur H qui peut être comprise entre plusieurs centaines de nanomètres et plusieurs micromètres, les pores pouvant être séparés entre eux de régions 11a d'épaisseur e qui peut être comprise entre 10 nm et plusieurs centaines de nanomètres, par exemple de l'ordre de 100 nm (figure 8A).

Pour empêcher une porosification de couches sous-jacentes à la couche que l'on souhaite rendre poreuse, et par exemple éviter d'atteindre une région d'électrode du capteur sur laquelle la structure poreuse fonctionnalisée est formée, on peut prévoir, comme sur la figure 8A, une couche barrière 81 intermédiaire sur laquelle la couche rendue poreuse repose. Dans le cas où l'on effectue une porosification d'aluminium, on peut prévoir une couche barrière 81 résistante à une anodisation de l'aluminium et par exemple à base de Ti. La nature et l'épaisseur de la couche barrière 81 sont définies en fonction de la compatibilité avec l'empilement sur lequel elle est déposée et de son comportement sélectif par rapport à l'anodisation de l'aluminium.

Une fois la structure poreuse réalisée, on forme dans les pores 12 au moins une couche de fonctionnalisation 13 apte à adsorber ou absorber au moins une espèce chimique cible, par exemple sous forme de gaz (figure 8B). Le matériau de la couche de fonctionnalisation que l'on souhaite former peut être un matériau hybride organique-inorganique, ou un matériau micro-poreux ou nano-poreux, ou un matériau polymère ou plus généralement un matériau difficile à structurer en particulier par photolithographie.

Le matériau poreux servant de matrice d'accueil à la couche de fonctionnalisation a quant à lui une épaisseur et une forme bien définies.

Selon un mode de réalisation du procédé on effectue un remplissage en phase liquide du matériau poreux. Le remplissage peut être réalisé par une dispense sur toute la surface du support ou localement par sérigraphie, par exemple à l'aide d'une solution sol-gel. Les caractéristiques topographiques de la structure poreuse, en particulier l'état de surface et le diamètre des pores 12, ainsi que les propriétés de la solution de dépôt liquide en termes de mouillabilité et de tension superficielle de surface sont prévus de telle sorte que le liquide remplisse uniformément la structure poreuse.

Dans le cas d'un matériau poreux à base d'Al₂O₃ un prétraitement n'est pas nécessairement effectué pour préparer le remplissage. Pour d'autres types de matériaux poreux, on peut mettre en œuvre un traitement hydrophile préalable de la structure poreuse par exemple à l'aide d'un plasma. Ensuite, on effectue un dépôt de SiO₂, ou d'un polymère de type chitosan ou de Polyétherimide (PEI) afin d'améliorer l'accroche.

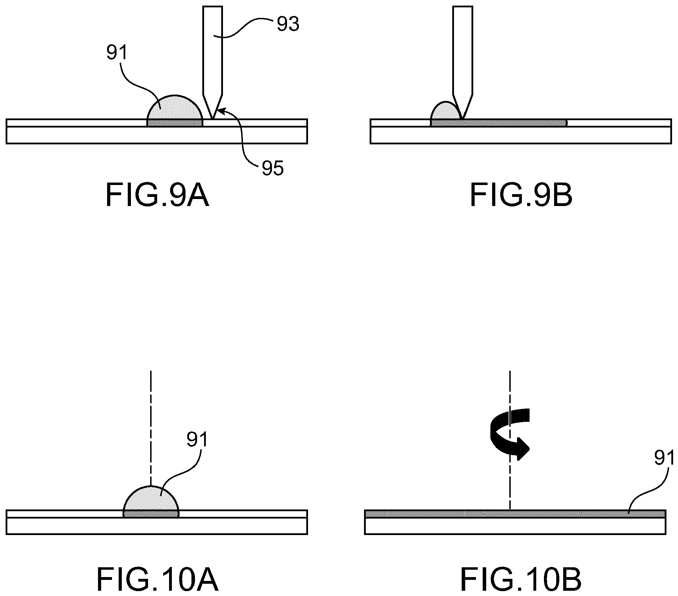

Une méthode particulière de remplissage des pores 12, que l'on appellera « raclage » est illustrée sur les figures 9A-9B.

Cette méthode apparentée à la sérigraphie comprend le dépôt d'une solution 91 d'intérêt pour former la couche de fonctionnalisation, puis un étalement de cette solution 91 au moyen d'une racle 93, par exemple en polymère. La racle 93 peut être munie d'une extrémité 95 comportant des arêtes ayant une forme en V, c'est-à-dire réalisant un angle aigu. Dans ce cas, la racle 93 a une double fonction. Elle permet d'étaler la solution uniformément sur la surface du support sur lequel on effectue le dépôt. La forme en « V » de l'extrémité 95 de la racle en contact avec le support exerce une force sur la solution facilitant le remplissage des pores 12. La racle 93 permet également de retirer un surplus de la solution 91 que l'on souhaite éliminer en surface du support.

Une autre technique de remplissage illustrée sur les figures 10A-10B consiste à réaliser une enduction par centrifugation (« spin coating » selon la terminologie anglo-saxonne).

Cette méthode de remplissage comprend le dépôt d'une solution d'intérêt sur un support qui est mis en rotation autour de son centre et la solution s'étale alors à l'aide de la force centrifuge. L'épaisseur finale dépend des propriétés de la solution et de paramètres tels que l'accélération du support, la vitesse angulaire du support, la durée de la mise en rotation. La solution 91 est déposée au centre du support puis une mise en rotation est déclenchée, à une vitesse par exemple de l'ordre de 2000t/min pendant une durée qui peut être de l'ordre de 2min. La solution 91 s'étale alors sur le support et pénètre dans les pores 12.

Un procédé tel que décrit précédemment permet de former une structure de détection dotée d'un matériau poreux qui tout en ayant une forme et une épaisseur contrôlées peut intégrer un matériau habituellement incompatible avec la photolithographie, par exemple un matériau polymère ou un matériau hybride organique-inorganique.

Selon une variante de mise en œuvre du procédé, on peut vouloir intégrer plusieurs couches de fonctionnalisation dans le matériau poreux, un pore de ce matériau pouvant alors comprendre un empilement de couches de fonctionnalisation.

Dans ce cas, on peut effectuer un dépôt conforme d'une première couche de fonctionnalisation 13 tel que cela est illustré sur la figure 11.

Un tel dépôt est de préférence réalisé en phase gazeuse. Les parois des pores 12 peuvent être alors tapissées d'un matériau sensible à un premier gaz ou une première espèce chimique donnée. Le matériau déposé est par exemple un polymère tel que du FDTS (Perfluorodecyltrichlorosilane) ou du EBTMOS (3,4-epoxybutyltrimethoxysilane). Le dépôt en phase gazeuse sur une structure poreuse permet de générer une couche de fonctionnalisation avec une surface développée importante par rapport à une surface lisse planaire avec un rapport de surface variant de 1 à 100.

Une variante au dépôt en phase gazeuse est un dépôt en phase liquide d'une solution diluée dans un solvant, une évaporation du solvant étant ensuite effectuée.

On effectue le dépôt de sorte que la première couche de fonctionnalisation 13 tapisse la surface des pores 12 et qu'un volume vide 111 soit préservé.

On peut alors ensuite remplir au moins ce volume vide 111 par une deuxième couche de fonctionnalisation de sorte à obtenir un agencement tel qu'illustré sur la figure 2. Cette deuxième couche de fonctionnalisation peut être réalisée en phase liquide ou gazeuse selon l'une ou l'autre des techniques données précédemment.

Ensuite, on effectue une gravure du ou des matériaux de remplissage déposés en excédant et dépassant de la surface du matériau poreux. Une gravure par RIE (pour « Reactive Ion Etching ») par exemple à l'aide de CHF₃-O₂, en particulier 100 sccm de CHF₃, 20 sccm d'O₂ avec une détection de fin d'attaque sur l'aluminium ou sur l'alumine.

Lors de l'étape de dépôt en phase liquide ou en phase gazeuse pour former la ou les couches de fonctionnalisation, on peut être amené à protéger certaines régions du support sur lequel se trouve le matériau poreux. Parmi les régions que l'on est susceptible de protéger figurent notamment des plots de contact. Lorsque l'on dispense un produit liquide, un masque de sérigraphie peut servir de protection, tandis que pour réaliser un dépôt en phase vapeur, on peut se servir d'un masque troué pour ne dévoiler que certaines zones du matériau poreux.

Selon une variante de mise en œuvre du procédé, et en particulier de la formation de la couche de fonctionnalisation par dépôt en phase liquide on peut prévoir de former des régions hydrophobes sur le matériau poreux afin de favoriser le dépôt sélectif de produit liquide sur certaines zones cibles du matériau poreux. Le dépôt de la couche de fonctionnalisation peut être réalisé par enduction par centrifugation (« spin coating » selon la terminologie anglo-saxonne).

Selon une variante de mise en œuvre du procédé, avant anodisation de la couche que l'on souhaite rendre poreuse, on peut effectuer une gravure préalable de certaines zones de cette couche destinées à être rendues poreuses par oxydation anodique, en particulier lorsque la couche est en aluminium. Cela peut permettre de limiter la topographie finale sur la face supérieure de la couche du matériau poreux. La transformation de l'aluminium en alumine se traduit par une augmentation de volume de l'ordre de 20% à 40% selon la tension, le courant, la température et le bain utilisés. Si l'on n'anodise qu'une zone localisée de l'aluminium, l'alumine formée sera plus haute que l'aluminium autour de la zone localisée. Afin de compenser cela, il est possible de graver préalablement la couche d'aluminium dans la zone localisée afin de retirer une partie de une épaisseur correspondant à un gain de volume estimé.

Un procédé suivant l'invention peut s'appliquer à la formation de structures poreuses fonctionnalisées réalisées à partir d'autres matériaux poreux que l'alumine par exemple à partir de Si poreux.

Un exemple de fonctionnalisation de matériau poreux dans lequel on forme une couche de fonctionnalisation par dépôt conforme sur les parois des pores puis une autre couche de fonctionnalisation par dépôt volumique remplissant les pores a été décrit précédemment.

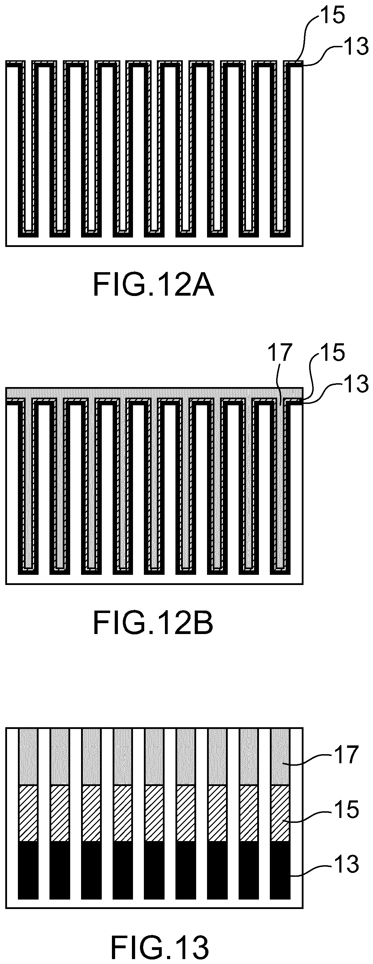

Il est également possible de remplir les pores 12 par des dépôts conformes successifs de plusieurs matériaux actifs 13, 15 afin de tapisser les parois et le fond des pores d'un empilement de couches de fonctionnalisation, tout en gardant un volume central vide (figure 12A).

Après une telle succession de dépôts conformes on peut également finaliser la fonctionnalisation et le remplissage des pores 12 par un dépôt volumique de matériau 17 permettant de combler le volume vide restant des pores 12 (figure 12B).

Une autre variante de réalisation consiste à déposer plusieurs matériaux actifs en volume par dépôts successifs alternés avec des gravures plasma afin de réaliser un empilement de couches de fonctionnalisation 13, 15, 17 tel qu'illustré sur la figure 13, chacune en contact avec des parois d'un pore 12.

## Revendications

1. Capteur chimique doté d'au moins une structure de détection résonante, ladite structure de détection étant munie d'au moins une matrice d'accueil à base de matériau poreux (11) **caractérisé en ce que**
les pores (12) sont tapissés ou remplis d'au moins une première couche de fonctionnalisation (13) à base d'un premier matériau organique micro-poreux ou nano-poreux apte à adsorber et/ou absorber au moins une première espèce chimique,
le matériau poreux (11) est revêtu d'une couche de fermeture (19)
des pores (12), la couche de fermeture (19) étant disposée sur, ou au-dessus de, la ou des couches de fonctionnalisation et étant apte à laisser une ou plusieurs espèces chimiques pénétrer à l'intérieur des pores et à empêcher une ou plusieurs autres espèces chimiques pénétrer à l'intérieur des pores.

2. Capteur chimique selon la revendication 1, le premier matériau organique étant choisi parmi les matériaux suivants : matériau hybride organique-inorganique, matériau polymère.

3. Capteur selon l'une des revendications 1 ou 2, dans lequel les pores (12) sont tapissés par la première couche de fonctionnalisation (13) et en outre remplis au moins partiellement d'au moins une deuxième couche de fonctionnalisation (15) disposée sur et en contact de la première couche de fonctionnalisation (13), la deuxième couche de fonctionnalisation étant apte à adsorber et/ou absorber au moins une deuxième espèce chimique, la deuxième couche de fonctionnalisation (15) étant à base d'un deuxième matériau organique différent dudit premier matériau organique.

4. Capteur chimique selon la revendication 3, le deuxième matériau étant choisi parmi les matériaux suivants : matériau hybride organique-inorganique, matériau micro-poreux ou nano-poreux présentant une fonction organique, matériau polymère.

5. Capteur chimique selon l'une quelconque des revendications 3 ou 4, dans lequel au moins une parmi lesdites couches de fonctionnalisation (13) et (15) est adaptée pour adsorber et/ou absorber du CO₂, au moins une autre couche parmi lesdites couches de fonctionnalisation (13) et (15) étant adaptée pour adsorber et/ou absorber du H₂.

6. Capteur chimique résonant selon l'une des revendications 1 à 5, la couche de fermeture (19) des pores étant hydrophobe.

7. Capteur chimique selon les revendications 1 à 6, dans lequel le premier matériau organique présente une fonction organique à base de silane ou étant à base de silice microporeuse rendue organique.

8. Procédé de réalisation du capteur chimique défini à l'une des revendications 1 à 7, comprenant la formation de la matrice d'accueil à partir d'une couche base de matériau poreux (11) dont les pores (12) sont tapissés ou remplis d'au moins la première couche de fonctionnalisation (13) à base du premier matériau organique micro-poreux ou nano-poreux apte à adsorber et/ou absorber la première espèce chimique,
ladite première couche de fonctionnalisation (13) étant formée par dépôt en phase liquide ou gazeux d'une solution sur tout ou partie de la couche de matériau poreux,
le matériau poreux (11) étant ensuite revêtu d'une couche de fermeture (19) des pores (12), la couche de fermeture (19) étant disposée sur, ou au-dessus de, la première couche de fonctionnalisation et étant apte à laisser une ou plusieurs espèces chimiques pénétrer à l'intérieur des pores et à empêcher une ou plusieurs autres espèces chimiques pénétrer à l'intérieur des pores.

9. Procédé selon la revendication 8, comprenant en outre, après ledit dépôt en phase liquide une étape de mise en rotation d'un support sur lequel la couche de matériau poreux est disposé.

10. Procédé selon la revendication 8, comprenant en outre, après ledit dépôt en phase liquide une étape d'étalement de ladite solution liquide au moyen d'une racle.

11. Procédé de réalisation du capteur chimique défini à l'une des revendications 1 à 7, comprenant la formation d'une matrice d'accueil à base de matériau poreux (11) dont les pores (12) sont tapissés ou remplis d'au moins une première couche de fonctionnalisation (13) à base d'un premier matériau organique micro-poreux ou nano-poreux apte à adsorber et/ou absorber au moins une première espèce chimique,
dans lequel ladite première couche de fonctionnalisation (13) est formée par dépôt conforme de sorte à tapisser tout ou partie des pores tout en laissant au moins un volume vide dans les pores, les pores étant ensuite au moins partiellement remplis ou tapissés d'un deuxième matériau de sorte à former dans ledit volume au moins une deuxième couche de fonctionnalisation (15) disposée sur et en contact de la première couche de fonctionnalisation (13),
le matériau poreux (11) étant revêtu ensuite d'une couche de fermeture (19) des pores (12), la couche de fermeture (19) étant disposée sur, ou au-dessus desdites couches de fonctionnalisation et étant apte à laisser une ou plusieurs espèces chimiques pénétrer à l'intérieur des pores et à empêcher une ou plusieurs autres espèces chimiques pénétrer à l'intérieur des pores.

12. Procédé de réalisation du capteur chimique défini à l'une des revendications 1 à 7, comprenant la formation de la matrice d'accueil à base de matériau poreux (11) dont les pores (12) sont tapissés ou remplis de la première couche de fonctionnalisation (13) à base d'un premier matériau organique micro-poreux ou nano-poreux apte à adsorber et/ou absorber la première espèce chimique,
dans lequel ladite couche à base de matériau poreux (11) est formée par oxydation anodique,
le matériau poreux (11) étant revêtu ensuite d'une couche de fermeture (19) des pores (12), la couche de fermeture (19) étant disposée sur, ou au-dessus de la première couche de fonctionnalisation et étant apte à laisser une ou plusieurs espèces chimiques pénétrer à l'intérieur des pores et à empêcher une ou plusieurs autres espèces chimiques pénétrer à l'intérieur des pores.

13. Procédé selon la revendication 12, dans lequel la couche à base de matériau poreux (11) est formée par oxydation anodique d'une couche d'aluminium la couche d'aluminium reposant sur une couche barrière à l'oxydation.

## Patentansprüche

1. Chemischer Sensor, der mit zumindest einer Resonanz-Detektionsstruktur versehen ist, wobei die Detektionsstruktur mit zumindest einer Trägermatrix auf Basis von porösem Material (11) versehen ist,
**dadurch gekennzeichnet, dass** die Poren (12) mit zumindest einer ersten Funktionalisierungsschicht (13) auf Basis eines ersten mikroporösen oder nanoporösen organischen Materials, das zumindest eine erste chemische Spezies adsorbieren und/oder absorbieren kann, ausgekleidet oder gefüllt sind, wobei das poröse Material (11) mit einer Verschlussschicht (19) der Poren (12) beschichtet ist, wobei die Verschlussschicht (19) auf oder über der bzw. den Funktionalisierungsschicht(en) angeordnet und dazu geeignet ist, eine oder mehrere chemische Spezies in das Innere der Poren eindringen zu lassen und eine oder mehrere andere chemische Spezies am Eindringen in das Innere der Poren zu hindern.

2. Chemischer Sensor nach Anspruch 1, wobei das erste organische Material aus den folgenden Materialien ausgewählt ist: organisch-anorganisches Hybridmaterial, polymeres Material.

3. Sensor nach einem der Ansprüche 1 oder 2, wobei die Poren (12) mit der ersten Funktionalisierungsschicht (13) ausgekleidet sind und ferner zumindest teilweise mit zumindest einer zweiten Funktionalisierungsschicht (15) gefüllt sind, die auf der ersten Funktionalisierungsschicht (13) angeordnet ist und in Kontakt mit dieser steht, wobei die zweite Funktionalisierungsschicht dazu geeignet ist, zumindest eine zweite chemische Spezies zu adsorbieren und/oder zu absorbieren, wobei die zweite Funktionalisierungsschicht (15) auf einem zweiten organischen Material basiert, das sich von dem ersten organischen Material unterscheidet.

4. Chemischer Sensor nach Anspruch 3, wobei das zweite Material aus den folgenden Materialien ausgewählt ist: organisch-anorganisches Hybridmaterial, mikro- oder nanoporöses Material mit einer organischen Funktion, polymeres Material.

5. Chemischer Sensor nach einem der Ansprüche 3 oder 4, wobei zumindest eine der Funktionalisierungsschichten (13) und (15) dazu geeignet ist, CO₂ zu adsorbieren und/oder zu absorbieren, wobei zumindest eine weitere Schicht aus den Funktionalisierungsschichten (13) und (15) dazu geeignet ist, H₂ zu adsorbieren und/oder zu absorbieren.

6. Chemischer Resonanzsensor nach einem der Ansprüche 1 bis 5, wobei die Verschlussschicht (19) der Poren hydrophob ist.

7. Chemischer Sensor nach einem der Ansprüche 1 bis 6, wobei das erste organische Material eine organische Funktion auf Basis von Silan aufweist oder auf mikroporösem Siliciumdioxid basiert, das organisch ausgebildet ist.

8. Verfahren zur Herstellung eines chemischen Sensors nach einem der Ansprüche 1 bis 7, umfassend das Ausbilden der Trägermatrix aus einer Schicht auf Basis von porösem Material (11), dessen Poren (12) mit zumindest einer ersten Funktionalisierungsschicht (13) auf Basis des ersten mikroporösen oder nanoporösen organischen Materials, das zumindest eine erste chemische Spezies adsorbieren und/oder absorbieren kann, ausgekleidet oder gefüllt sind, wobei die erste Funktionalisierungsschicht (13) durch Flüssig- oder Gasphasenabscheidung einer Lösung auf der gesamten oder einem Teil der porösen Materialschicht gebildet wird, wobei das poröse Material (11) dann mit einer Verschlussschicht (19) der Poren (12) beschichtet wird, wobei die Verschlussschicht (19) auf oder über der ersten Funktionalisierungsschicht angeordnet wird und dazu geeignet ist, eine oder mehrere chemische Spezies in das Innere der Poren eindringen zu lassen und eine oder mehrere andere chemische Spezies am Eindringen in das Innere der Poren zu hindern.

9. Verfahren nach Anspruch 8, ferner umfassend nach der Flüssigphasenabscheidung einen Schritt des Umdrehens eines Trägers, auf dem die Schicht aus porösem Material angeordnet ist.

10. Verfahren nach Anspruch 8, ferner umfassend nach der Flüssigphasenabscheidung einen Schritt des Verteilens der flüssigen Lösung mit Hilfe eines Rakels.

11. Verfahren zur Herstellung des chemischen Sensors nach einem der Ansprüche 1 bis 7, umfassend das Ausbilden einer Trägermatrix auf Basis von porösem Material (11), dessen Poren (12) mit zumindest einer ersten Funktionalisierungsschicht (13) auf Basis eines ersten mikroporösen oder nanoporösen organischen Materials, das zumindest eine erste chemische Spezies adsorbieren und/oder absorbieren kann, ausgekleidet oder gefüllt sind, wobei die erste Funktionalisierungsschicht (13) durch entsprechende Abscheidung so ausgebildet wird, dass sie alle oder einen Teil der Poren auskleidet, während zumindest ein leeres Volumen in den Poren belassen wird, wobei die Poren dann zumindest teilweise mit einem zweiten Material gefüllt oder ausgekleidet werden, um in dem Volumen zumindest eine zweite Funktionalisierungsschicht (15) zu bilden, die auf der ersten Funktionalisierungsschicht (13) angeordnet und mit dieser in Kontakt ist, wobei das poröse Material (11) dann mit einer Verschlussschicht (19) der Poren (12) beschichtet wird, wobei die Verschlussschicht (19) auf oder über den Funktionalisierungsschichten angeordnet wird und dazu geeignet ist, eine oder mehrere chemische Spezies in das Innere der Poren eindringen zu lassen und eine oder mehrere andere chemische Spezies am Eindringen in das Innere der Poren zu hindern.

12. Verfahren zur Herstellung des chemischen Sensors nach einem der Ansprüche 1 bis 7, umfassend das Ausbilden der Trägermatrix auf Basis von porösem Material (11), dessen Poren (12) mit der ersten Funktionalisierungsschicht (13) auf Basis eines ersten mikroporösen oder nanoporösen organischen Materials, das zumindest die erste chemische Spezies adsorbieren und/oder absorbieren kann, ausgekleidet oder gefüllt sind, wobei die auf porösem Material (11) basierende Schicht durch anodische Oxidation gebildet wird,
wobei das poröse Material (11) dann mit einer Verschlussschicht (19) der Poren (12) beschichtet wird, wobei die Verschlussschicht (19) auf oder über der Funktionalisierungsschicht angeordnet wird und dazu geeignet ist, eine oder mehrere chemische Spezies in das Innere der Poren eindringen zu lassen und eine oder mehrere andere chemische Spezies am Eindringen in das Innere der Poren zu hindern.

13. Verfahren nach Anspruch 12, wobei die auf porösem Material (11) basierende Schicht durch anodische Oxidation einer Aluminiumschicht gebildet wird, wobei die Aluminiumschicht auf einer Oxidationssperrschicht aufliegt.

## Claims

1. A chemical sensor provided with at least one resonant detection structure, said detection structure being provided with at least one receiving matrix based on a porous material (11), **characterized in that**:
- the pores are covered or filled with at least one first functionalisation layer (13) based on a first microporous or nanoporous organic material provided to adsorb and/or absorb at least one first chemical species,
the porous material (11) being coated with a closure layer (19) of the pores, the closure layer being arranged on or above the first functionalisation layer and being provided to allow one or several chemical species to penetrate inside the pores and to prevent one or several other chemical species from penetrating inside the pores.

2. The chemical sensor according to claim 1, the first organic material being chosen from the following materials: organic-inorganic hybrid material, polymer material.

3. The chemical sensor according to any of the claims 1 or 2, wherein the pores (12) are covered with the first functionalisation layer (13) and furthermore filled at least partially with at least one second functionalisation layer (15) arranged on and in contact with the first functionalisation layer (13), the second functionalisation layer being able to adsorb and/or absorb at least one second chemical species, the second functionalisation layer (15) being based on a second organic material, different from said first organic material.

4. The chemical sensor according to claim 3, the second material being chosen from the following materials: organic-inorganic hybrid material, microporous or nanoporous material having an organic function, polymer material.

5. The chemical sensor according to any of the claims 3 or 4, wherein at least one among said functionalisation layers (13) and (15) is provided to adsorb and/or absorb CO₂, at least one other layer among said functionalisation layers (13) and (15) is suitable for adsorbing and/or absorbing H₂.

6. The chemical sensor according to any of the claims 1 to 5, the closure layer (19) of the pores being hydrophobic.

7. The chemical sensor according to any of the claims 1 to 6, wherein the first organic material has an organic function based on silane or being based on microporous silica rendered organic.

8. A Method for producing a chemical sensor according to any of the claims 1 to 7, comprising the forming of the receiving matrix based on a porous material (11) layer, the pores of which are covered or filled with at least one first functionalisation layer (13) based on a first microporous or nano-porous organic material provided to adsorb and/or absorb at least one first chemical species,
the first functionalisation layer is formed by liquid or gas phase deposition of a solution on all or a portion of the layer of porous material,
the porous material (11) being then coated with the closure layer (19) of the pores, the closure layer being arranged on or above a first functionalisation layer and being provided to allow one or several chemical species to penetrate inside the pores and to prevent one or several other chemical species from penetrating inside the pores.

9. The method according to claim 8, further comprising, after said liquid phase deposition a step of rotating a support on which the layer of porous material is arranged.

10. The method according to claim 8, further comprising, after said liquid phase deposition a step of spreading said liquid solution by means of a scraper.

11. A Method for producing a chemical sensor according to any of the claims 1 to 7, comprising the forming of the receiving matrix based on a porous material (11) layer, the pores of which are covered or filled with at least one first functionalisation layer (13) based on a first microporous or nano-porous organic material provided to adsorb and/or absorb at least one first chemical species,
the first functionalisation layer is formed by compliant deposition in such a way as to cover all or a portion of the pores while leaving at least one empty volume in the pores, the pores being then at least partially filled or covered with a second material in such a way as to form in said volume at least one second functionalisation layer arranged on and in contact with the first functionalisation layer,
the porous material (11) being then coated with the closure layer (19) of the pores (12), the closure layer (19) being arranged on or above a first functionalisation layer and being provided to allow one or several chemical species to penetrate inside the pores and to prevent one or several other chemical species from penetrating inside the pores.

12. A method for producing a chemical sensor according to any of the claims 1 to 7, comprising the forming of the receiving matrix based on a porous material (11) layer, the pores of which are covered or filled with at least one first functionalisation layer (13) based on a first microporous or nano-porous organic material provided to adsorb and/or absorb at least one first chemical species,
wherein the layer based on a porous material is formed by anodic oxidation,
the porous material (11) being then coated with the closure layer (19) of the pores (12), the closure layer (19) being arranged on or above a first functionalisation layer and being provided to allow one or several chemical species to penetrate inside the pores and to prevent one or several other chemical species from penetrating inside the pores.

13. The method for producing a chemical sensor according to claim 12, wherein the layer based on a porous material is formed by anodic oxidation of an aluminium layer, the aluminium layer being arranged on an oxidation barrier layer.
